# FASCICULE DE BREVET EUROPEEN

(11) **EP 3 369 178 B1**
(45) Date de publication et mention de la délivrance du brevet: **06.10.2021**
(21) Numéro de dépôt: 16787810.7
(22) Date de dépôt: 25.10.2016
(51) Int. Cl.: H03K 17/16, H02M 1/38

(54) **DISPOSITIF DE COMMANDE POUR TRANSISTORS**
STEUERUNGSVORRICHTUNG FÜR TRANSISTOREN
CONTROL DEVICE FOR TRANSISTORS

(30) Priorité: 28.10.2015 FR 1560330
(43) Date de publication de la demande: 05.09.2018
(73) Titulaire: Valeo Siemens eAutomotive France SAS, 95800 Cergy (FR)
(72) Inventeur: BOUCHEZ, Boris, 95800 Cergy (FR); GRENIER, Mathieu, 78800 Houilles (FR); DA COSTA, José-Louis, 95130 Franconville (FR)
(74) Mandataire: Argyma
(86) Numéro de dépôt international: PCT/EP2016/075666
(87) Numéro de publication internationale: WO 2017/072113

(56) Documents cités:
- EP-A1- 2 816 728
- WO-A1-2014/009668

## Description

La présente invention concerne le domaine des dispositifs de commande des transistors, notamment les transistors de puissance utilisés dans les véhicules automobiles, par exemple au niveau des convertisseurs.

Les transistors sont en effet couramment utilisés dans les convertisseurs comme par exemple les onduleurs. Les dispositifs de commande de ces transistors sont configurés pour injecter ou non un courant au niveau de l'électrode de commande du transistor pour le rendre passant ou le rendre bloquant.

Cependant, lors du blocage du transistor, une surtension peut apparaître entre les électrodes autres que l'électrode de commande ce qui peut dégrader le transistor.

Pour éviter ces surtensions, il existe différentes solutions dans l'état de la technique mais ces solutions présentent généralement un inconvénient comme un coût élevé ou une réaction trop lente ou des pertes électriques induites importantes.

De manière à surmonter ces inconvénients, un dispositif auxiliaire visant à limiter la surtension et réduire les pertes par commutation est décrit dans le document FR2993422 dans lequel on détecte la tension aux bornes d'une impédance reliée à l'une des électrodes autres que l'électrode de commande. Le document EP2816728A1 décrit un autre circuit de commande de transistor connu. Cependant, dans le cas d'un convertisseur comprenant un bras ou demi-pont alimenté par un générateur de tension E dans lequel sont mis en série deux interrupteurs K1 et K2 montés en série, comme représenté sur la figure 1, un interrupteur K1, K2 comprenant un transistor T1, T2 et une diode D1, D2, dite diode de roue-libre, montée en anti-parallèle du transistor T1, T2, cette solution peut créer un court-circuit au niveau du bras (fermeture simultanée des deux interrupteurs K1 et K2) et endommager les équipements électriques reliés au convertisseur comme un moteur électrique ou une batterie. En effet, lors de l'ouverture du premier transistor T1, un courant peut circuler dans la diode de roue libre D1 associée au premier transistor T1, la diode D1 étant alors passante. Puis, lorsque la diode D1 se bloque, il y a alors une variation de courant durant une phase appelée phase de recouvrement. Cette variation de courant crée une tension au niveau de l'impédance associée au premier transistor T1 de sorte que le dispositif auxiliaire lié au premier transistor T1 peut rendre le premier transistor T1 passant. Or, si le deuxième transistor T2 est passé dans un mode passant pendant la phase de recouvrement de la première diode D1, un court-circuit est créé au niveau du bras. Il convient donc de trouver une solution permettant de piloter un transistor T1, T2 sans endommager ce dernier et en empêchant la mise en court-circuit d'un bras comprenant deux transistors T1 et T2 montés en série.

A cet effet, la présente invention a pour objet un dispositif de commande d'au moins un transistor, dit transistor commandé, comprenant :
- ledit transistor commandé, ce dernier comprenant une électrode de commande et deux autres électrodes,
- un circuit de commande principal relié à l'électrode de commande du transistor commandé et configuré pour, selon un mode de fonctionnement principal, commander l'état du transistor commandé et,
- un circuit de commande auxiliaire configuré pour, selon un mode de fonctionnement auxiliaire, injecter un courant auxiliaire s'opposant au courant circulant entre le circuit de commande principal et l'électrode de commande du transistor commandé,
   caractérisé en ce que le dispositif de commande comprend également un circuit de contrôle du circuit de commande auxiliaire, ledit circuit de contrôle étant configuré pour bloquer ou autoriser le fonctionnement auxiliaire du circuit de commande auxiliaire en fonction de commandes du circuit de commande principal.

Le circuit de commande principal peut donc être configuré pour commander le circuit de contrôle du circuit de commande auxiliaire pour bloquer le fonctionnement auxiliaire du circuit de commande auxiliaire notamment lorsque le transistor commandé devient bloquant ou pour autoriser le fonctionnement auxiliaire du circuit de commande auxiliaire.

Selon l'invention, le circuit de contrôle comprend également un premier élément de commutation configuré pour permettre la conduction électrique entre le circuit de commande auxiliaire et l'électrode de commande du transistor commandé ou pour interrompre ladite conduction électrique.

Selon l'invention le circuit de contrôle comprend un second élément de commutation correspondant à un transistor de type MOSFET à canal N dont :
- la grille est reliée au circuit de commande principal et notamment à l'organe de commande du circuit de commande principal,
- le drain est relié d'une part à une première source de tension et d'autre part à l'électrode de commande du premier élément de commutation et,
- la source est reliée à une deuxième source de tension dont la tension est inférieure à la tension de la première source de tension.

Selon un autre aspect de la présente invention, le circuit de commande principal comprend un composant logique programmable configuré pour générer des signaux de modulation à largeur d'impulsion et un organe de commande configuré pour recevoir les signaux de modulation à largeur d'impulsion issus d'un composant logique et les transformer en signaux de commande du transistor commandé.

Selon un aspect additionnel de la présente invention, le circuit de commande auxiliaire est configuré pour fonctionner selon un mode de fonctionnement auxiliaire lorsqu'une condition prédéfinie concernant la valeur de la dérivée temporelle du courant circulant entre les électrodes du transistor commandé autres que l'électrode de commande est vérifiée.

Selon un aspect supplémentaire de la présente invention, le circuit de commande auxiliaire est configuré pour asservir la valeur de la dérivée temporelle du courant circulant entre les électrodes du transistor autres que l'électrode de commande autour d'une valeur de consigne.

Selon un autre aspect de la présente invention, dans lequel le circuit de commande auxiliaire comprend un organe de détection et un organe d'injection, ledit organe d'injection étant configuré pour injecter un courant auxiliaire s'opposant au courant circulant entre le circuit de commande principal et l'électrode de commande du transistor commandé lorsqu'il reçoit une tension issue de l'organe de détection.

Selon un aspect additionnel de la présente invention, l'organe de détection comprend un transistor, dit transistor de détection, relié à un capteur de courant mesurant le courant circulant dans le transistor commandé entre les électrodes autres que l'électrode de commande, le capteur de courant comprenant une impédance et un pont diviseur de tension, comprenant une première et une deuxième résistances, monté en parallèle de l'impédance, l'électrode de commande du transistor de détection est reliée au point milieu du pont diviseur de tension, l'électrode de puissance positive du transistor de détection est reliée à une borne de l'impédance, notamment via un filtre RC, et l'électrode de puissance négative du transistor de détection est reliée à l'organe d'injection.

Selon un autre aspect de la présente invention, le circuit de commande auxiliaire comprend un organe de détection et un organe d'injection, ledit organe de détection étant configuré pour transmettre une tension à l'organe d'injection lorsque la dérivée temporelle du courant circulant entre les électrodes du transistor commandé autres que l'électrode de commande dépasse un seuil prédéterminé, ledit organe d'injection étant configuré pour injecter un courant auxiliaire s'opposant au courant circulant entre le circuit de commande principal et l'électrode de commande du transistor commandé lorsqu'il reçoit une tension issue de l'organe de détection.

Selon un aspect supplémentaire de la présente invention, l'organe d'injection comprend un transistor, dit transistor d'injection dont l'électrode de commande est reliée à l'organe de détection et à la première source de tension via une résistance, l'électrode de puissance positive du transistor d'injection est reliée à la première source de tension et l'électrode de tension négative est reliée à l'électrode de commande positive du premier élément de commutation du circuit de contrôle.

Selon un autre aspect de la présente invention, l'électrode de puissance négative du premier élément de commutation du circuit de contrôle est reliée à l'électrode de commande du transistor commandé.

Selon un aspect additionnel de la présente invention, l'électrode de puissance négative du premier élément de commutation du circuit de contrôle est reliée à l'entrée d'un montage amplificateur de puissance, notamment de type « push-pull », disposé entre le circuit de commande principal et l'électrode de commande du transistor commandé, le circuit de commande auxiliaire étant disposé de manière à ce que ce montage amplificateur de puissance soit traversé par le courant injecté lorsque le mode de fonctionnement auxiliaire est appliqué.

Selon un aspect supplémentaire de la présente invention, l'électrode de puissance négative du premier élément de commutation du circuit de contrôle est reliée à une résistance, dite résistance de commande, disposée entre le circuit de commande principal et l'électrode de commande du transistor commandé, au niveau de la borne de la résistance de commande qui n'est pas connectée à l'électrode de commande du transistor commandé.

La présent invention concerne également un circuit de commande d'une branche comprenant au moins un premier et un deuxième éléments commandés montés en série, un élément commandé comprenant une diode montée en anti-parallèle avec un transistor commandé, et au moins un premier et un deuxième dispositifs de commande, selon l'une des revendications précédentes, associés respectivement auxdits premier et deuxième éléments commandés, lesdits premier et deuxième dispositifs de commande étant configurés pour mettre leur transistor commandé associé respectif dans un état passant de manière alternative ou dans un état bloquant simultanément.

Selon un autre aspect de la présente invention, le premier dispositif de commande est configuré pour :
- bloquer le fonctionnement auxiliaire du circuit de commande auxiliaire associé au premier transistor commandé lorsque le deuxième dispositif de commande pilote un passage à l'état passant du deuxième transistor commandé,
- autoriser le fonctionnement auxiliaire du circuit de commande auxiliaire associé au premier transistor commandé lorsque ledit premier dispositif de commande pilote un passage à l'état bloquant du premier élément commandé,
et dans lequel le deuxième dispositif de commande est configuré pour :
- bloquer le fonctionnement auxiliaire du circuit de commande auxiliaire associé au deuxième transistor commandé lorsque le premier dispositif de commande pilote un passage à l'état passant du premier transistor commandé,
- autoriser le fonctionnement auxiliaire du circuit de commande auxiliaire associé au deuxième transistor commandé lorsque ledit deuxième dispositif de commande pilote un passage à l'état bloquant du deuxième transistor commandé.

La présente invention concerne également un convertisseur électrique comprenant au moins une branche comprenant un premier et un deuxième éléments commandés montés en série et au moins un circuit de commande des éléments commandés.

D'autres caractéristiques et avantages de l'invention apparaîtront dans la description qui va maintenant en être faite, en référence aux dessins annexés qui en représentent, à titre indicatif mais non limitatif, des modes de réalisation possibles.

Sur ces dessins:
- la figure 1 représente un schéma d'un bras d'un onduleur comprenant deux interrupteurs montés en série ;
- la figure 2 représente un schéma simplifié d'un circuit de commande d'un transistor selon la présente invention ;
- la figure 3 représente un schéma détaillé d'un circuit de commande d'un transistor selon la présente invention ;
- la figure 4 représente un schéma d'un circuit de commande selon un mode de réalisation de la présente invention ;
- la figure 5 représente un graphique représentant un exemple de signaux de commande d'un circuit de commande selon la figure 4.

Sur ces figures, les mêmes numéros de référence désignent des éléments ayant une fonction identique.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées pour fournir d'autres réalisations.

Dans la description qui va suivre, on désigne de façon générale:
Le terme «IGBT» renvoie à l'acronyme anglais Insulated Gate Bipolar Transistor et correspond à un transistor de type bipolaire à grille isolée;

Le terme « MOSFET » renvoie à l'acronyme anglais Métal Oxyde Semiconductor Filed Effect Transistor et correspond à un transistor à effet de champ à grille métal-oxyde.

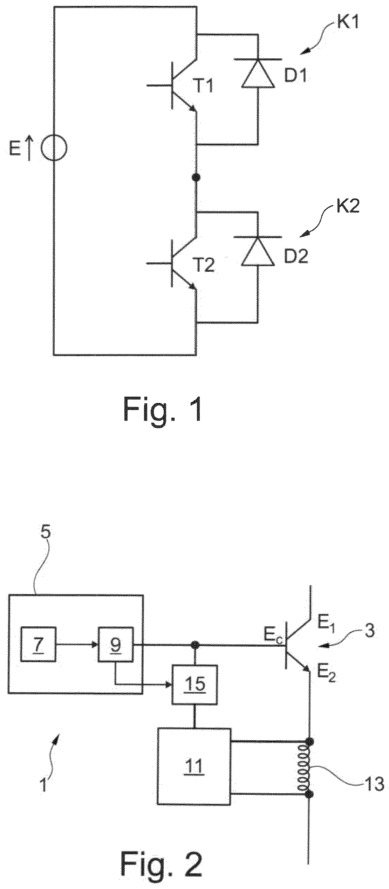

La figure 2 représente un schéma simplifié d'un dispositif de commande 1 d'un transistor, dit transistor commandé 3, selon la présente invention. Le dispositif de commande 1 comprend le transistor commandé 3 qui comprend trois électrodes : une électrode de commande notée E_{c} et deux autres électrodes notées E₁ et E₂. Le transistor commandé 3 est par exemple un transistor de type bipolaire à grille isolée (IGBT en anglais) ou de type à effet de champ à grille métal-oxyde (MOSFET en anglais).

Le dispositif de commande 1 comprend également un circuit de commande principal 5 relié à l'électrode de commande E_{c} du transistor commandé 3 et configuré pour commander l'état du transistor commandé 3 selon un mode de fonctionnement principal. Le circuit de commande principal 5 comprend notamment un composant logique programmable 7 configuré pour générer des signaux de modulation à largeur d'impulsion (pulse width modulation (PWM) en anglais) destinés à piloter l'ouverture et la fermeture du transistor commandé 3 et un organe de commande 9 (aussi appelé driver en anglais) configuré pour recevoir les signaux de modulation à largeur d'impulsion issus du composant logique programmable 7 et les transformer en signaux de commande adaptés pour piloter le transistor commandé 3.

Le dispositif de commande 1 comprend également un circuit de commande auxiliaire 11 configuré pour injecter un courant auxiliaire s'opposant au courant circulant entre le circuit de commande principal 5 et l'électrode de commande E_{c} du transistor commandé 3 selon un mode de fonctionnement auxiliaire. Le passage du mode de fonctionnement principal au mode de fonctionnement auxiliaire étant piloté par le circuit de commande principal 5. Ce pilotage sera décrit plus en détail dans la suite de la description. Le circuit de commande auxiliaire 11 est également configuré pour détecter le courant circulant entre les électrodes E₁ et E₂ du transistor commandé 3 autres que l'électrode de commande E_{c} et notamment pour déterminer la valeur de la dérivée temporelle du courant circulant entre les électrodes E₁ et E₂ du transistor commandé 3 autres que l'électrode de commande E_{c}. Le courant auxiliaire est injecté par le circuit de commande auxiliaire 11 lorsqu'une condition concernant la valeur de la dérivée temporelle déterminée est vérifiée. La valeur de la dérivée temporelle du courant est par exemple déterminée en mesurant la tension aux bornes d'une impédance 13 reliée à une électrode E₂ du transistor commandé 3 autre que l'électrode de commande E_{c}.

Le dispositif de commande 1 comprend également un circuit de contrôle 15 du circuit de commande auxiliaire 11, ledit circuit de contrôle 15 étant configuré pour bloquer ou autoriser le fonctionnement auxiliaire du circuit de commande auxiliaire 11 en fonction de commandes du circuit de commande principal 5.

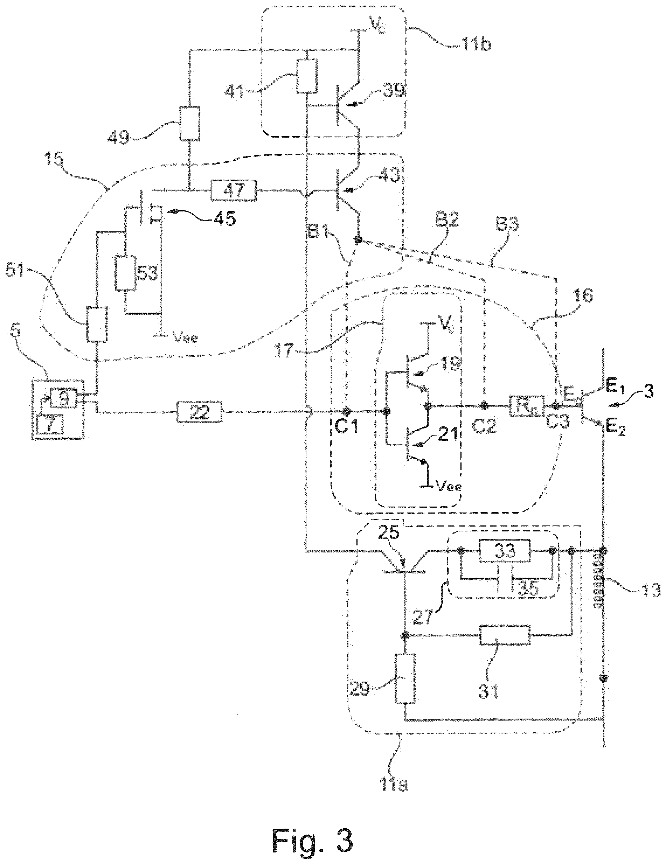

Le dispositif de commande 1 va maintenant être décrit plus en détails à partir de la figure 3.

Des éléments de commande 16 peuvent être introduit entre le circuit de commande principal 5 et l'électrode de commande E_{c} du transistor commandé 3. Ces éléments de commande 16 comprennent par exemple un amplificateur 17 de type push-pull. Cet amplificateur 17 est réalisé par un premier 19 et un deuxième 21 transistors dont les électrodes de commande sont reliées entre elles et à la sortie du circuit de commande principal 5, par exemple via une résistance 22. Les transistors 19 et 21 de l'amplificateur 17 sont par exemple des transistors de type bipolaires. L'électrode de puissance positive du premier transistor 19 est reliée à une première source de tension notée V_{c}. L'électrode de puissance négative du premier transistor 19 est reliée d'une part à l'électrode de puissance positive du deuxième transistor 21 et d'autre part à l'électrode de commande E_{c} du transistor commandé 3 via une résistance R_{c} dite résistance de commande. L'électrode de puissance négative du deuxième transistor 21 est reliée à une deuxième source de tension notée Vₑₑ, le niveau de tension de la deuxième source de tension Vₑₑ étant inférieur au niveau de tension de la première source de tension V_{c}, la tension V_{c} est par exemple comprise entre 7 et 20V, notamment 15V et la tension Vₑₑ est par exemple comprise entre 5 et 15V

La résistance de commande R_{c} fait également partie des éléments de commande 16.

Le circuit de commande auxiliaire 11 comprend un organe de détection 11a configuré pour détecter la tension au niveau de l'impédance 13. L'organe de détection 11a comprend un transistor 25 dit transistor de détection qui est par exemple de type bipolaire ou de type MOSFET. L'organe de détection 11a peut également comprendre un filtre 27 de type RC et un pont diviseur de tension comprenant une première 29 et une deuxième 31 résistances pour adapter la tension détectée aux bornes de l'impédance 13 au transistor de détection 25. Dans ce cas, la première 29 et la deuxième 31 résistances sont disposées en série dans une branche montée en parallèle avec l'impédance 13 et l'électrode de commande du transistor de détection 25 est reliée au point milieu de la branche entre la première 29 et de la deuxième 31 résistances. Une première électrode du transistor de détection 25 autre que l'électrode de commande est reliée à une première borne du filtre RC 27 comprenant une résistance 33 en parallèle avec un condensateur 35, la deuxième borne du filtre RC 27 étant reliée entre l'impédance 13 et la deuxième électrode E₂ du transistor commandé 3. L'ensemble comprenant l'impédance 13 et le pont diviseur aux bornes de l'impédance 13, voire le filtre RC 27, forme donc un capteur de courant pour l'électrode de commande du transistor de détection 25, ledit capteur de courant mesurant le courant circulant entre les bornes E1 et E2 du transistor commandé 3 autres que l'électrode de commande E_{c}.

Le circuit de commande auxiliaire 11 comprend également un organe d'injection 11b configuré pour injecter un courant auxiliaire entre le circuit de commande principal 5 et l'électrode de commande E_{c} du transistor commandé 3. L'organe d'injection 11b comprend un transistor 39 dit transistor d'injection, par exemple de type bipolaire ou MOSFET, dont l'électrode de commande est reliée d'une part à la deuxième électrode du transistor de détection 25 autre que l'électrode de commande et d'autre part à une source de tension, par exemple la première source de tension V_{c}, via une résistance 41. Une première électrode du transistor d'injection 39 autre que l'électrode de commande est reliée à ladite source de tension, par exemple la première source de tension V_{c}. Une deuxième électrode du transistor d'injection 39 est destinée à être reliée entre le circuit de commande principal 5 et le transistor commandé 3, par exemple à l'une des bornes d'un des éléments de commande 16. Ainsi, lorsque la valeur de la tension aux bornes de l'impédance 13 (qui est proportionnelle à la dérivée temporelle du courant traversant les électrodes E₁ et E₂ autres que l'électrode de commande E_{c} du transistor commandé 3) dépasse un seuil prédéterminé, le transistor de détection 25 devient passant, ce qui rend le transistor d'injection 39 passant de sorte qu'un courant est injecté entre le circuit de commande principal 5 et le transistor commandé 3. Ce courant injecté provoque le passage à l'état passant du transistor commandé 3.

Le circuit de commande auxiliaire 11 forme donc une boucle de rétroaction configurée pour asservir la valeur de la dérivée temporelle du courant circulant entre les électrodes E₁ et E₂ autres que l'électrode de commande E_{c} du transistor commandé 3 autour d'une valeur de consigne. Cette boucle de rétroaction permet donc de réduire, voire de supprimer les surtensions au niveau du transistor commandé 3. En effet, si, lors du passage à l'état bloquant du transistor commandé 3, la surtension est trop forte, le circuit de commande auxiliaire 11 provoque le passage à l'état passant du transistor commandé 3 de sorte que le passage de l'état passant à l'état bloquant se fait plus lentement ce qui réduit voire supprime les surtensions.

Le circuit de contrôle 15 du circuit de commande auxiliaire 11 comprend un premier élément de commutation 43 disposé entre le circuit de commande auxiliaire 11 et les éléments de commande 16 situés entre le circuit de commande principal 5 et l'électrode de commande E_{c} du transistor commandé 3 pour autoriser ou non la mise en conduction de l'organe d'injection 39 et de l'électrode de commande E_{c}, notamment via les éléments de commande 16. Le premier élément de commutation 43 dit premier transistor de commutation est par exemple réalisé par un transistor de type bipolaire ou MOSFET. La première électrode du premier transistor de commutation 43 autre que l'électrode de commande est reliée à la deuxième électrode du transistor d'injection 39 et la deuxième électrode du premier transistor de commutation 43 autre que l'électrode de commande est reliée à un point de connexion située entre le circuit de commande principal 5 et l'électrode de commande E_{c} du transistor commandé 3.

Selon un premier mode de réalisation représenté par la branche B1 (représentée en pointillés), le point de connexion est un premier point de connexion C1 situé entre le circuit de commande principal 5 et l'amplificateur 17, notamment entre la résistance 22 et l'amplificateur 17.

Selon un deuxième mode de réalisation, alternatif au premier mode de réalisation, représenté par la branche B2 (représentée en pointillés), le point de connexion C2 est situé entre l'amplificateur 17 et la résistance de commande R_{c}.

Selon un troisième mode de réalisation, alternatif au premier et au deuxième mode de réalisation, représenté par la branche B3 (représentée en pointillés), le point de connexion C3 est situé entre la résistance de commande R_{c} et l'électrode de commande du transistor commandé 3.

Il est à noter que le fonctionnement du dispositif de commande 1 est le même pour les trois modes de réalisation.

L'électrode de commande du premier transistor de commutation 43 est reliée à un deuxième élément de commutation 45 via une résistance 47. Le deuxième élément de commutation 45 dit deuxième transistor de commutation est par exemple réalisé par un transistor de type MOSFET à canal N dont le drain est relié d'une part à l'électrode de commande du premier transistor de commutation 43 via la résistance 47 et d'autre part à la première électrode du transistor d'injection 39 via une résistance 49. La grille du deuxième transistor de commutation 45 est reliée d'une part à une sortie dédiée de l'organe de commande 9 via une résistance 51 et à une source de tension, par exemple la deuxième source de tension Vₑₑ, via une résistance 53. La source du deuxième transistor de commutation 45 est également reliée à ladite source de tension, par exemple la deuxième source de tension Vₑₑ. La sortie dédiée de l'organe de commande 9 correspond à une sortie distincte de la sortie de commande du transistor commandé 3. Les signaux de commande associés à la sortie dédiée du circuit de contrôle 15 du circuit de commande auxiliaire 11 vont être décrits dans la suite de la description.

Ainsi, lorsqu'un signal émis par la sortie dédiée de l'organe de commande 9 rend passant le deuxième transistor de commutation 45, la tension au niveau de l'électrode de commande du premier transistor de commutation 43 diminue ce qui rend le premier transistor de commutation 43 bloquant. Le transistor d'injection 39 n'est alors plus en conduction électrique avec l'un des points de connexion C1, C2 ou C3 de sorte que le circuit de commande auxiliaire 11 est inhibé et ne peut plus injecter de courant au niveau de l'électrode de commande E_{c} du transistor commandé 3 et ne peut donc plus rendre le transistor commandé 3 passant.

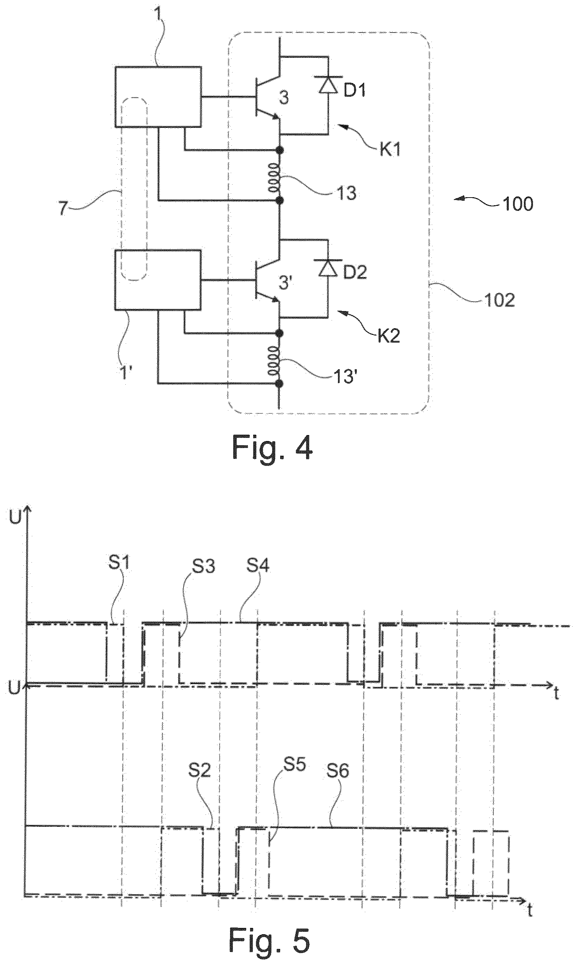

La figure 4 représente un circuit de commande 100 correspondant par exemple à un convertisseur et comprenant une branche 102 avec un premier K1 et un deuxième K2 éléments commandés et un premier 1 et un deuxième 1' circuits de commande tel que décrit précédemment et associés respectivement au premier K1 et au deuxième K2 éléments commandés. Un élément commandé K1, K2 comprend un transistor commandé 3, 3' et une diode D1, D2 montée en antiparallèle au transistor commandé 3, 3' ainsi qu'une impédance 13, 13'.

Avec une telle architecture, le composant logique programmable 7 du circuit de commande principal peut être commun au premier 1 et au deuxième 1' circuits de commande (d'autres éléments comme l'organe de commande 9 peuvent également être communs au premier 1 et au deuxième 1' circuits de commande). Ainsi, le composant logique programmable 7 génère des signaux de modulation à largeur d'impulsions pour commander l'ouverture et la fermeture du premier 3 et du deuxième 3' transistors commandés.

La figure 5 représente un exemple de graphique des signaux de commande S1 et S2 destinés à commander respectivement le premier 3 et le deuxième 3' transistors commandés. Le graphique représente le niveau de tension U des signaux de commande envoyés à l'électrode de commande E_{c} pour le premier 3 et le deuxième 3' transistor en fonction du temps t, la partie haute du graphique correspondant aux signaux destinés au premier circuit de commande 1 et la partie basse du graphique correspondant aux signaux destinés au deuxième circuit de commande 1'. On peut observer sur le graphique que les deux signaux S1 et S2 ne sont jamais au niveau haut simultanément (pour éviter un court-circuit dans la branche).

Pour permettre un bon fonctionnement du circuit de commande 100, le signal de commande destiné au circuit de contrôle 15 associé au premier transistor commandé 3 doit être à un niveau bas lors des fronts descendants du signal S1, c'est-à-dire lorsque le premier transistor commandé 3 passe d'un état passant à un état bloquant, et doit être à un niveau haut lors des fronts montants du signal S2, c'est-à-dire lorsque le deuxième transistor commandé 3' passe d'un état bloquant à un état passant.

Le signal de commande destiné au circuit de contrôle 15 associé au premier transistor commandé 3 doit donc avoir un front montant après le passage à l'état bloquant du premier transistor commandé 3 et avant le passage à l'état passant du deuxième transistor commandé 3'.

Le signal S3, respectivement S4, représente donc un exemple d'un signal de commande destiné au circuit de contrôle 15 associé au premier transistor commandé 3 pour lequel la durée au niveau haut est minimale, respectivement maximale.

De la même manière, le signal de commande destiné au circuit de contrôle 15 associé au deuxième transistor commandé 3' doit être au niveau bas lors des fronts descendants du signal S2, c'est-à-dire lorsque le deuxième transistor commandé 3' passe d'un état passant à un état bloquant, et doit être à un niveau haut lors des fronts montants du signal S1, c'est-à-dire lorsque le premier transistor commandé 3 passe d'un état bloquant à un état passant.

Le signal de commande destiné au circuit de contrôle 15 associé au deuxième transistor commandé 3' doit donc avoir un front montant après le passage à l'état bloquant du deuxième transistor commandé 3' et avant le passage à l'état passant du premier transistor commandé 3.

Le signal S5, respectivement S6, représente donc un exemple d'un signal de commande destiné au circuit de contrôle 15 associé au deuxième transistor commandé 3' pour lequel la durée au niveau haut est minimale, respectivement maximale.

Ainsi, l'utilisation de tels signaux de commande dans une branche 102 d'un convertisseur 100 permettent d'une part d'éviter les surtensions lors du passage de l'état passant à l'état bloquant d'un transistor commandé 3 du fait de l'utilisation d'un circuit de commande auxiliaire 11 qui procure une boucle de rétroaction au transistor commandé 3 et d'autre part d'éviter un court-circuit dans la branche 102 en inhibant l'action du circuit de commande auxiliaire 11 lors du passage de l'état bloquant à l'état passant de l'autre transistor commandé 3' de la branche 102. De plus, les éléments du circuit de contrôle 15 peuvent être aisément intégrés avec les éléments du circuit de commande principal 5 et du circuit de commande auxiliaire 11 de sorte que l'implémentation de la présente invention ne présente pas de difficulté et a un coût réduit.

## Revendications

1. Dispositif de commande (1) d'au moins un transistor, dit transistor commandé (3), comprenant :
- ledit transistor commandé (3), ce dernier comprenant une électrode de commande (E_{c}) et deux autres électrodes (E₁ et E₂),
- un circuit de commande principal (5) relié à l'électrode de commande (E_{c}) du transistor commandé (3) et configuré pour, selon un mode de fonctionnement principal, commander l'état du transistor commandé (3) et,
- un circuit de commande auxiliaire (11) configuré pour, selon un mode de fonctionnement auxiliaire, injecter un courant auxiliaire s'opposant au courant circulant entre le circuit de commande principal (5) et l'électrode de commande (E_{c}) du transistor commandé (3), le dispositif de commande (1) comprenant également un circuit de contrôle (15) du circuit de commande auxiliaire (11), ledit circuit de contrôle (15) comprenant un premier élément de commutation (43) configuré pour mettre en conduction électrique le circuit de commande auxiliaire (11) et l'électrode de commande (E_{c}) du transistor commandé (3) pour autoriser le mode de fonctionnement auxiliaire ou pour interrompre ladite conduction électrique et bloquer le mode de fonctionnement auxiliaire, en fonction de commandes du circuit de commande principal (5), **caractérisé en ce que** le circuit de contrôle (15) comprend un second élément de commutation (45) correspondant à un transistor de type MOSFET à canal N dont :
- la grille est reliée au circuit de commande principal (5),
- le drain est relié d'une part à une première source de tension (V_{c}) et d'autre part à une électrode
de commande du premier élément de commutation (43) et,
- la source est reliée à une deuxième source de tension (Vₑₑ) dont la tension est inférieure à la tension de la première source de tension (V_{c}).

2. Dispositif de commande (1) selon la revendication 1, dans lequel le circuit de commande principal (5) comprend un composant logique programmable (7) configuré pour générer des signaux de modulation à largeur d'impulsion et un organe de commande (9) configuré pour recevoir les signaux de modulation à largeur d'impulsion issus d'un composant logique (7) et les transformer en signaux de commande du transistor commandé (3).

3. Dispositif de commande (1) selon l'une des revendications précédentes dans lequel le circuit de commande auxiliaire (11) est configuré pour fonctionner selon un mode de fonctionnement auxiliaire lorsqu'une condition prédéfinie concernant la valeur de la dérivée temporelle du courant circulant entre les électrodes (E1, E2) du transistor commandé (3) autres que l'électrode de commande (E_{c}) est vérifiée.

4. Dispositif de commande (1) selon la revendication 3, dans lequel le circuit de commande auxiliaire (11) est configuré pour commander la valeur de la dérivée temporelle du courant circulant entre les électrodes du transistor (E1, E2) autres que l'électrode de commande (E_{c}) en fonction d'une valeur de consigne.

5. Dispositif de commande (1) selon l'une des revendications précédentes, dans lequel le circuit de commande auxiliaire (11) comprend un organe de détection (11a) et un organe d'injection (11b), ledit organe d'injection (11b) étant configuré pour injecter un courant auxiliaire s'opposant au courant circulant entre le circuit de commande principal (5) et l'électrode de commande (E_{c}) du transistor commandé (3) lorsqu'il reçoit une tension issue de l'organe de détection (11a).

6. Dispositif de commande (1) selon la revendication 5, dans lequel l'organe de détection (11a) comprend un transistor (25), dit transistor de détection, relié à un capteur de courant mesurant le courant circulant dans le transistor commandé (3) entre les électrodes (E1, E2) autres que l'électrode de commande (E_{c}), le capteur de courant comprenant une impédance (13) et un pont diviseur de tension, comprenant une première (29) et une deuxième (31) résistances, monté en parallèle de l'impédance (13), l'électrode de commande (E_{c}) du transistor de détection (25) est reliée au point milieu du pont diviseur de tension, l'électrode de puissance positive du transistor de détection (25) est reliée à une borne de l'impédance (13), notamment via un filtre RC (27), et l'électrode de puissance négative du transistor de détection (25) est reliée à l'organe d'injection (11b).

7. Dispositif de commande (1) selon la revendication 5 ou 6, dans lequel l'organe d'injection (11b) comprend un transistor (39), dit transistor d'injection dont l'électrode de commande est reliée à l'organe de détection (11a) et à la première source de tension (V_{c}) via une résistance (41), l'électrode de puissance positive du transistor d'injection (39) est reliée à la première source de tension (V_{c}) et l'électrode de tension négative est reliée à l'électrode de commande positive du premier élément de commutation (43) du circuit de contrôle (15).

8. Dispositif de commande (1) selon la revendication 7, dans lequel l'électrode de puissance négative du premier élément de commutation (43) du circuit de contrôle (15) est reliée à l'électrode de commande (E_{c}) du transistor commandé (3).

9. Dispositif de commande (1) selon la revendication 7, dans lequel l'électrode de puissance négative du premier élément de commutation (43) du circuit de contrôle (15) est reliée à l'entrée d'un montage amplificateur de puissance (17), notamment de type « push-pull », disposé entre le circuit de commande principal (5) et l'électrode de commande (E_{c}) du transistor commandé (3), le circuit de commande auxiliaire (11) étant disposé de manière à ce que ce montage amplificateur de puissance (17) soit traversé par le courant injecté lorsque le mode de fonctionnement auxiliaire est appliqué.

10. Dispositif de commande (1) selon la revendication 7, dans lequel l'électrode de puissance négative du premier élément de commutation (43) du circuit de contrôle (15) est reliée à une résistance (R_{c}), dite résistance de commande, disposée entre le circuit de commande principal (5) et l'électrode de commande (E_{c}) du transistor commandé (3), au niveau de la borne de la résistance de commande (R_{c}) qui n'est pas connectée à l'électrode de commande (E_{c}) du transistor commandé.

11. Circuit de commande (100) d'une branche (102) comprenant au moins un premier (K1) et un deuxième (K2) éléments commandés montés en série, un élément commandé comprenant une diode (D1, D2) montée en anti-parallèle avec un transistor commandé (3, 3'), et au moins un premier (1) et un deuxième (1') dispositifs de commande, selon l'une des revendications précédentes, associés respectivement auxdits premier (3) et deuxième (3') éléments commandés, lesdits premier (1) et deuxième (1') dispositifs de commande étant configurés pour mettre leur transistor commandé (3, 3') associé respectif dans un état passant de manière alternative ou dans un état bloquant simultanément.

12. Circuit de commande (100) selon la revendication 11, dans lequel le premier dispositif de commande (1) est configuré pour :
- bloquer le fonctionnement auxiliaire du circuit de commande auxiliaire (11) associé au premier transistor commandé (3) lorsque le deuxième dispositif de commande (1') pilote un passage à l'état passant du deuxième transistor commandé (3'),
- autoriser le fonctionnement auxiliaire du circuit de commande auxiliaire (11) associé au premier transistor commandé (3) lorsque ledit premier dispositif de commande (1) pilote un passage à l'état bloquant du premier élément commandé (3),
et dans lequel le deuxième dispositif de commande (1') est configuré pour :
- bloquer le fonctionnement auxiliaire du circuit de commande auxiliaire (11) associé au deuxième transistor commandé (3') lorsque le premier dispositif de commande (1) pilote un passage à l'état passant du premier transistor commandé (3),
- autoriser le fonctionnement auxiliaire du circuit de commande auxiliaire (11) associé au deuxième transistor commandé (3') lorsque ledit deuxième dispositif de commande (1') pilote un passage à l'état bloquant du deuxième transistor commandé (3').

13. Convertisseur électrique comprenant au moins une branche (102) comprenant un premier (K1) et un deuxième (K2) éléments commandés montés en série et au moins un circuit de commande (100) selon la revendication 11 ou 12.

## Patentansprüche

1. Steuerungsvorrichtung (1) für mindestens einen Transistor, gesteuerter Transistor (3) genannt, umfassend:
- den gesteuerten Transistor (3), wobei Letzterer eine Steuerelektrode (E_{c}) und zwei andere Elektroden (E₁ und E₂) umfasst,
- einen Hauptsteuerschaltkreis (5), der mit der Steuerelektrode (E_{c}) des gesteuerten Transistors (3) verbunden und dazu konfiguriert ist, den Zustand des gesteuerten Transistors (3) gemäß einem Hauptbetriebsmodus zu steuern, und
- einen Hilfssteuerschaltkreis (11), der dazu konfiguriert ist, gemäß einem Hilfsbetriebsmodus einen Hilfsstrom einzuspeisen, der dem Strom entgegengerichtet ist, der zwischen dem Hauptsteuerschaltkreis (5) und der Steuerelektrode (E_{c}) des gesteuerten Transistors (3) fließt,
wobei die Steuerungsvorrichtung (1) auch einen Überwachungsschaltkreis (15) für den Hilfssteuerschaltkreis (11) umfasst, wobei der Überwachungsschaltkreis (15) ein erstes Schaltelement (43) umfasst, das dazu konfiguriert ist, den Hilfssteuerschaltkreis (11) und die Steuerelektrode (E_{c}) des gesteuerten Transistors (3) in elektrisch leitenden Zustand zu versetzen, um in Abhängigkeit von Befehlen des Hauptsteuerschaltkreises (5) den Hilfsbetriebsmodus zu erlauben oder die elektrische Leitung zu unterbrechen und den Hilfsbetriebsmodus zu sperren, **dadurch gekennzeichnet, dass** der Überwachungsschaltkreis (15) ein zweites Schaltelement (45) umfasst, das einem Transistor vom Typ N-Kanal-MOSFET entspricht:
- dessen Gate mit dem Hauptsteuerschaltkreis (5) verbunden ist,
- dessen Drain einerseits mit einer ersten Spannungsquelle (V_{c}) und andererseits mit einer Steuerelektrode des ersten Schaltelements (43) verbunden ist, und
- dessen Source mit einer zweiten Spannungsquelle (Vₑₑ) verbunden ist, deren Spannung kleiner ist als die Spannung der ersten Spannungsquelle (V_{c}).

2. Steuerungsvorrichtung (1) nach Anspruch 1, wobei der Hauptsteuerschaltkreis (5) einen programmierbaren Logikbaustein (7), der dazu konfiguriert ist, Pulsbreitenmodulationssignale zu erzeugen, und ein Steuerorgan (9) umfasst, das dazu konfiguriert ist, die Pulsbreitenmodulationssignale aus einem Logikbaustein (7) zu empfangen und sie in Steuersignale für den gesteuerten Transistor (3) umzuwandeln.

3. Steuerungsvorrichtung (1) nach einem der vorhergehenden Ansprüche, wobei der Hilfssteuerschaltkreis (11) dazu konfiguriert ist, gemäß einem Hilfsbetriebsmodus zu arbeiten, wenn eine vordefinierte Bedingung bezüglich des Wertes der zeitlichen Ableitung des Stroms, der zwischen den anderen Elektroden (E1, E2) des gesteuerten Transistors (3) als der Steuerelektrode (E_{c}) fließt, bestätigt wird.

4. Steuerungsvorrichtung (1) nach Anspruch 3, wobei der Hilfssteuerschaltkreis (11) dazu konfiguriert ist, den Wert der zeitlichen Ableitung des Stroms, der zwischen den anderen Elektroden (E1, E2) als der Steuerelektrode (E_{c}) fließt, in Abhängigkeit von einem Sollwert zu steuern.

5. Steuerungsvorrichtung (1) nach einem der vorhergehenden Ansprüche, wobei der Hilfssteuerschaltkreis (11) ein Detektionsorgan (11a) und ein Einspeiseorgan (11b) umfasst, wobei das Einspeiseorgan (11b) dazu konfiguriert ist, einen Hilfsstrom einzuspeisen, der dem Strom entgegengerichtet ist, der zwischen dem Hauptsteuerschaltkreis (5) und der Steuerelektrode (E_{c}) des gesteuerten Transistors (3) fließt, wenn es eine Spannung aus dem Detektionsorgan (11a) empfängt.

6. Steuerungsvorrichtung (1) nach Anspruch 5, wobei das Detektionsorgan (11a) einen Transistor (25) umfasst, Detektionstransistor genannt, der mit einem Stromsensor verbunden ist, der den Strom misst, der im gesteuerten Transistor (3) zwischen den anderen Elektroden (E1, E2) als der Steuerelektrode (E_{c}) fließt, wobei der Stromsensor eine Impedanz (13) und eine Spannungsteilerbrücke umfasst, die einen ersten (29) und einen zweiten (31) Widerstand umfasst, die parallel zur Impedanz (13) geschaltet sind, die Steuerelektrode (E_{c}) des Detektionstransistors (25) mit dem Mittelpunkt der Spannungsteilerbrücke verbunden ist, die positive Leistungselektrode des Detektionstransistors (25) mit einem Impedanzanschluss (13) insbesondere über ein RC-Filter (27) verbunden ist und die negative Leistungselektrode des Detektionstransistors (25) mit dem Einspeiseorgan (11b) verbunden ist.

7. Steuerungsvorrichtung (1) nach Anspruch 5 oder 6, wobei das Einspeiseorgan (11b) einen Transistor (39) umfasst, Einspeisetransistor genannt, dessen Steuerelektrode über einen Widerstand (41) mit dem Detektionsorgan (11a) und der ersten Spannungsquelle (V_{c}) verbunden ist, wobei die positive Leistungselektrode des Einspeisetransistors (39) mit der ersten Spannungsquelle (V_{c}) verbunden ist und die negative Spannungselektrode mit der positiven Steuerelektrode des ersten Schaltelements (43) des Überwachungsschaltkreises (15) verbunden ist.

8. Steuerungsvorrichtung (1) nach Anspruch 7, wobei die negative Leistungselektrode des ersten Schaltelements (43) des Überwachungsschaltkreises (15) mit der Steuerelektrode (E_{c}) des gesteuerten Transistors (3) verbunden ist.

9. Steuerungsvorrichtung (1) nach Anspruch 7, wobei die negative Leistungselektrode des ersten Schaltelements (43) des Überwachungsschaltkreises (15) mit dem Eingang einer Leistungsverstärkeranordnung (17), insbesondere vom Typ "Push-Pull" verbunden ist, die zwischen dem Hauptsteuerschaltkreis (5) und der Steuerelektrode (E_{c}) des gesteuerten Transistors (3) angeordnet ist, wobei der Hilfssteuerschaltkreis (11) derart angeordnet ist, dass die Leistungsverstärkeranordnung (17) vom eingespeisten Strom durchflossen wird, wenn der Hilfsbetriebsmodus angewandt wird.

10. Steuerungsvorrichtung (1) nach Anspruch 7, wobei die negative Leistungselektrode des ersten Schaltelements (43) des Überwachungsschaltkreises (15) mit einem Widerstand (R_{c}), Steuerwiderstand genannt, verbunden ist, der zwischen dem Hauptsteuerschaltkreis (5) und der Steuerelektrode (E_{c}) des gesteuerten Transistors (3) am Anschluss des Steuerwiderstands (R_{c}) angeordnet ist, der nicht mit der Steuerelektrode (E_{c}) des gesteuerten Transistors verbunden ist.

11. Steuerschaltkreis (100) eines Zweigs (102), umfassend mindestens ein erstes (K1) und ein zweites (K2) gesteuertes Element, die in Reihe geschaltet sind, wobei ein gesteuertes Element eine Diode (D1, D2) umfasst, die antiparallel zu einem gesteuerten Transistor (3, 3') geschaltet ist, und mindestens eine erste (1) und eine zweite (1') Steuervorrichtung nach einem der vorhergehenden Ansprüche, die jeweils dem ersten (3) und dem zweiten (3') gesteuerten Element zugeordnet sind, wobei die erste (1) und die zweite (1') Steuervorrichtung dazu konfiguriert sind, ihren jeweiligen zugeordneten gesteuerten Transistor (3, 3') abwechselnd in einen Durchlasszustand oder gleichzeitig in einen Sperrzustand zu versetzen.

12. Steuerschaltkreis (100) nach Anspruch 11, wobei die erste Steuerungsvorrichtung (1) zu Folgendem konfiguriert ist:
- Sperren des Hilfsbetriebs des Hilfssteuerschaltkreises (11), der dem ersten gesteuerten Transistor (3) zugeordnet ist, wenn die zweite Steuerungsvorrichtung (1') einen Übergang des zweiten gesteuerten Transistors (3') in den Durchlasszustand steuert,
- Erlauben des Hilfsbetriebs des Hilfssteuerschaltkreises (11), der dem ersten gesteuerten Transistor (3) zugeordnet ist, wenn die erste Steuerungsvorrichtung (1) einen Übergang des ersten gesteuerten Elements (3) in den Sperrzustand steuert,
und wobei die zweite Steuerungsvorrichtung (1') zu Folgendem konfiguriert ist:
- Sperren des Hilfsbetriebs des Hilfssteuerschaltkreises (11), der dem zweiten gesteuerten Transistor (3') zugeordnet ist, wenn die erste Steuerungsvorrichtung (1) einen Übergang des ersten gesteuerten Transistors (3) in den Durchlasszustand steuert,
- Erlauben des Hilfsbetriebs des Hilfssteuerschaltkreises (11), der dem zweiten gesteuerten Transistor (3') zugeordnet ist, wenn die zweite Steuerungsvorrichtung (1') einen Übergang des zweiten gesteuerten Transistors (3') in den Sperrzustand steuert.

13. Elektrischer Wandler, umfassend mindestens einen Zweig (102), umfassend ein erstes (K1) und ein zweites (K2) gesteuertes Element, die in Reihe geschaltet sind, und mindestens einen Steuerschaltkreis (100) nach Anspruch 11 oder 12.

## Claims

1. Control device (1) for controlling at least one transistor, referred to as the controlled transistor (3), comprising:
- said controlled transistor (3), this comprising a control electrode (E_{c}) and two other electrodes (E₁ and E₂),
- a main control circuit (5) connected to the control electrode (E_{c}) of the controlled transistor (3) and configured to control, according to a main operating mode, the state of the controlled transistor (3), and
- an auxiliary control circuit (11) configured to inject, according to an auxiliary operating mode, an auxiliary current opposite to the current flowing between the main control circuit (5) and the control electrode (E_{c}) of the controlled transistor (3), the control device (1) further comprising a control circuit (15) for controlling the auxiliary control circuit (11), said control circuit (15) comprising a first switching element (43) configured to place the auxiliary control circuit (11) and the control electrode (E_{c}) of the controlled transistor (3) in electrical conduction so as to allow the auxiliary operating mode or to interrupt said electrical conduction and block the auxiliary operating mode according to commands from the main control circuit (5),
**characterized in that** the control circuit (15) comprises a second switching element (45) corresponding to an N-channel MOSFET transistor of which:
- the gate is connected to the main control circuit (5),
- the drain is connected both to a first voltage source (V_{c}) and to a control electrode for the first switching element (43), and
- the source is connected to a second voltage source (V_{cc}), the voltage of which is lower than the voltage of the first voltage source (V_{c}).

2. Control device (1) according to Claim 1, in which the main control circuit (5) comprises a programmable logic component (7) configured to generate pulse-width modulation signals and a control member (9) configured to receive the pulse-width modulation signals from a logic component (7) and transform them into control signals for the controlled transistor (3).

3. Control device (1) according to one of the preceding claims, in which the auxiliary control circuit (11) is configured to operate according to an auxiliary operating mode when a predefined condition relating to the value of the time derivative of the current flowing between the electrodes (E1, E2) of the controlled transistor (3) other than the control electrode (E_{c}) is satisfied.

4. Control device (1) according to Claim 3, in which the auxiliary control circuit (11) is configured to control the value of the time derivative of the current flowing between the electrodes of the transistor (E1, E2) other than the control electrode (E_{c}) according to a setpoint value.

5. Control device (1) according to one of the preceding claims, in which the auxiliary control circuit (11) comprises a detection member (11a) and an injection member (11b), said injection member (11b) being configured to inject an auxiliary current opposite to the current flowing between the main control circuit (5) and the control electrode (E_{c}) of the controlled transistor (3) when it receives a voltage from the detection member (11a) .

6. Control device (1) according to Claim 5, in which the detection member (11a) comprises a transistor (25), referred to as the detection transistor, connected to a current sensor that measures the current flowing through the controlled transistor (3) between the electrodes (El, E2) other than the control electrode (E_{c}), the current sensor comprising an impedance (13) and a voltage divider bridge, comprising a first (29) and a second (31) resistor, which is connected in parallel with the impedance (13), the control electrode (E_{c}) of the detection transistor (25) is connected to the midpoint of the voltage divider bridge, the positive power electrode of the detection transistor (25) is connected to a terminal of the impedance (13), in particular via an RC filter (27), and the negative power electrode of the detection transistor (25) is connected to the injection member (11b).

7. Control device (1) according to Claim 5 or 6, in which the injection member (11b) comprises a transistor (39), referred to as the injection transistor, the control electrode of which is connected to the detection member (11a) and to the first voltage source (V_{c}) via a resistor (41), the positive power electrode of the injection transistor (39) is connected to the first voltage source (V_{c}) and the negative voltage electrode is connected to the positive control electrode of the first switching element (43) of the control circuit (15).

8. Control device (1) according to Claim 7, in which the negative power electrode of the first switching element (43) of the control circuit (15) is connected to the control electrode (E_{c}) of the controlled transistor (3) .

9. Control device (1) according to Claim 7, in which the negative power electrode of the first switching element (43) of the control circuit (15) is connected to the input of a power amplifier circuit (17), in particular of "push-pull" type, arranged between the main control circuit (5) and the control electrode (E_{c}) of the controlled transistor (3), the auxiliary control circuit (11) being arranged such that that this power amplifier circuit (17) is passed through by the injected current when the auxiliary operating mode is applied.

10. Control device (1) according to Claim 7, in which the negative power electrode of the first switching element (43) of the control circuit (15) is connected to a resistor (R_{c}), referred to as the control resistor, arranged between the main control circuit (5) and the control electrode (E_{c}) of the controlled transistor (3), at level of the terminal of the control resistor (R_{c}) which is not connected to the control electrode (E_{c}) of the controlled transistor.

11. Control circuit (100) of a branch (102) comprising at least a first (K1) and a second (K2) controlled elements connected in series, a controlled element comprising a diode (Dl, D2) antiparallel-connected to a controlled transistor (3, 3'), and at least a first (1) and a second (1') control devices, according to one of the preceding claims, associated with said first (3) and second (3') controlled elements, respectively, said first (1) and second (1') control devices being configured to place their respective associated controlled transistor (3, 3') in an on state in alternation or in an off state simultaneously.

12. Control circuit (100) according to Claim 11, in which the first control device (1) is configured to:
- block the auxiliary operation of the auxiliary control circuit (11) associated with the first controlled transistor (3) when the second control device (1') drives a transition of the second controlled transistor (3') to the on state,
- allow the auxiliary operation of the auxiliary control circuit (11) associated with the first controlled transistor (3) when said first control device (1) drives a transition of the first controlled element (3) to the off state,
and in which the second control device (1') is configured to:
- block the auxiliary operation of the auxiliary control circuit (11) associated with the second controlled transistor (3') when the first control device (1) drives a transition of the first controlled transistor (3) to the on state,
- allow the auxiliary operation of the auxiliary control circuit (11) associated with the second controlled transistor (3') when said second control device (1') drives a transition of the second controlled transistor (3') to the off state.

13. Electrical converter comprising at least one branch (102) comprising a first (K1) and a second (K2) controlled elements that are connected in series and at least one control circuit (100) according to Claim 11 or 12.
